# EUROPEAN PATENT SPECIFICATION

(11) **EP 2 169 691 B1**
(45) Date of publication and mention of the grant of the patent: **30.11.2016**
(21) Application number: 09155223.2
(22) Date of filing: 16.03.2009
(51) Int. Cl.: H01F 27/14, G05D 16/06, E21B 33/038, H01F 27/23

(54) **Pressure compensator**
Druckkompensator
Compensateur de pression

(30) Priority: 24.09.2008 EP 08164976
(43) Date of publication of application: 31.03.2010
(73) Proprietor: ABB Schweiz AG, 5400 Baden (CH)
(72) Inventor: Uusipaikka, Usko, 65320, Vaasa (FI)
(74) Representative: Kolster Oy Ab

(56) References cited:
- GB-A- 1 023 452
- US-A1- 2004 202 401
- US-A1- 2007 074 872

## Description

The invention relates to a pressure compensator configured to compensate volume variations of an insulation medium or other liquid of a subsea installation, comprising a first bellows chamber comprising a first bellows part, the first bellows chamber being in flow connection with an insulation medium or other liquid chamber of the subsea installation and the walls of the first bellows chamber being configured to separate the insulating medium from surroundings.

Subsea installations are assemblies used underwater. Said assemblies can be installed for example on the bottom ground of a sea. As an example of said subsea installations power transformers used under water can be mentioned. Typically these power transformers use insulation medium, i.e. the transformers are fluid insulated ones having for example transformer oil in a transformer tank. Examples of the other subsea liquid filled objects are subsea motors, subsea switchgears, subsea converters, rectifiers and hydraulic store tanks.

The subsea installations described above are used for example in modern oil and gas production in which the collection, separation, boosting and transport of production fluids takes place on the seabed. These processes require large amounts of power that has to be transferred from a remote location at suitable voltages and currents for minimum power loss, to the subsea installations. The transport of the power preferably takes place at high voltages and low current to ensure minimum losses. When the power arrives at the subsea location, the power has to be transformed into more usable voltages and currents for the various specific subsea applications, such as for example the powering of pumps and compressors.

The large power requirements result in the need of large transformers placed in a protective environment inside a large vessel, i.e. a tank. The transformer tank must be filled with an insulating medium that ensures optimal working conditions for the transformer over many years. The preferred insulating medium comprises transformer oil that contributes towards dissipating heat and preventing shorts and flashovers. In new big subsea transformers the size of the transformer tank is typically in the order of 10-30 cubic meters containing 10 000 - 30 000 litres of transformer oil. The water temperature variations, heat produced by the transformer and the properties of typical transformer oil result in oil volume variation in the order of several hundred litres or more. As the size of a transformer tank increases, the problems and need of compression and expansion also increase accordingly.

As told above subsea installations, for example subsea transformers need pressure compensators to keep the pressure of the insulation medium used, for example the pressure of oil inside the transformer, close to the water pressure outside the transformer to avoid heavy mechanical structures against pressure. Also the cooling is easier when thinner wall thickness can be applied. The hydrostatic pressure of the water will increase circa 10 bars for each 100 m water depth increase and the pressure difference between the oil inside and the water outside is typically needed to be less that 1 bar. The subsea transformers filled with insulation oil will be exposed to oil compression and expansion due to temperature variation of the surrounding, due to load variation causing also the variation of the oil temperature and due to hydrostatic pressure of the sea water. The oil volume variation due to temperature variation is caused by oil property having non-zero thermal expansion coefficient and the oil volume variation due to pressure variation is caused by close to zero pressure-volume coefficient of the oil.

For construction point of views and reliability reasons the transformer vessels or other equipment tanks described above are typically rigid and constant volume structures and when transformer or equipment sizes are increasing this means that the pressure inside the transformer or other equipment must be close to water pressure around the transformer or the other equipment. Owing to the facts above said subsea transformers or the other equipments need one or several pressure compensators to keep the oil pressure inside the transformer close to the water pressure outside the transformer. Said pressure compensators are structures with variable volume oil or other liquid filled containers outside the transformer or the other equipment. Said variable volume containers are also in flow connection with the transformer oil space or the other equipment liquid space.

There are several different solutions for subsea pressure compensators. As examples of the prior art solutions PCT document WO 2007/055588 A1 and US Patent Application US 2004/0051615 A1. All prior art subsea pressure compensators, for example those mentioned above, have only one wall or barrier between the sea water and the oil inside. Said fact is a serious problem of the prior art subsea pressure compensators. This means that if one barrier or wall will have a failure producing leakage between the oil and the water, the water will enter into the transformer causing fatal electrical failure of the transformer and so end of the transformer operation. The other equipment will have also serious consequences like for example electrical failures if the water will leak in. Said leak problem relates mainly to corrosion caused by the sea water, i.e. prior art pressure compensators are not particularly resistant against corrosion caused by sea water. The sensitivity of the corrosion may be a risk with metallic bellows type pressure compensators because the wall of the bellows must be very thin to reach required flexibility. This may be the situation even when cathodic protection will be used.

There are also known solutions with which properties of different bellows structures against corrosion are improved. As examples of said solutions JP 9176766, JP 2000046181, EP 0 281 685 and US 5 893 681 can be mentioned. These known solutions are not however suitable in subsea conditions. As examples of the background art US 2001/0202401 A1 can be mentioned.

The object of the present invention is to obtain a pressure compensator, which eliminates the problems of the prior art. This is obtained by the present invention. The present invention is characterized in that the first bellows chamber is surrounded by a second bellows chamber comprising an end wall, a side wall and a second bellows part formed by a diaphragm, the second bellows chamber being configured to form a closed intermediate space around the first bellows chamber, the walls of the second bellows chamber being configured to separate at least the bellows parts of the first bellows chamber from the surrounding water, the second bellows chamber being further filled with an intermediate medium.

An advantage of the invention is that the problems relating to sea water corrosion are eliminated very efficiently. The present invention is also simple and therefore manufacturing and maintenance costs are low.

The invention will be described in the following in detail by means of the examples shown in the attached drawing, in which
Figure 1 shows schematically the basic structure and operation principle of the pressure compensator of the invention,
Figure 2 is a sectional drawing showing the pressure compensator of the invention in a compressed situation,
Figure 3 is a sectional drawing showing the pressure compensator of the invention in an expanded situation
Figure 4 shows schematically a subsea transformer provided with pressure compensators of the invention.

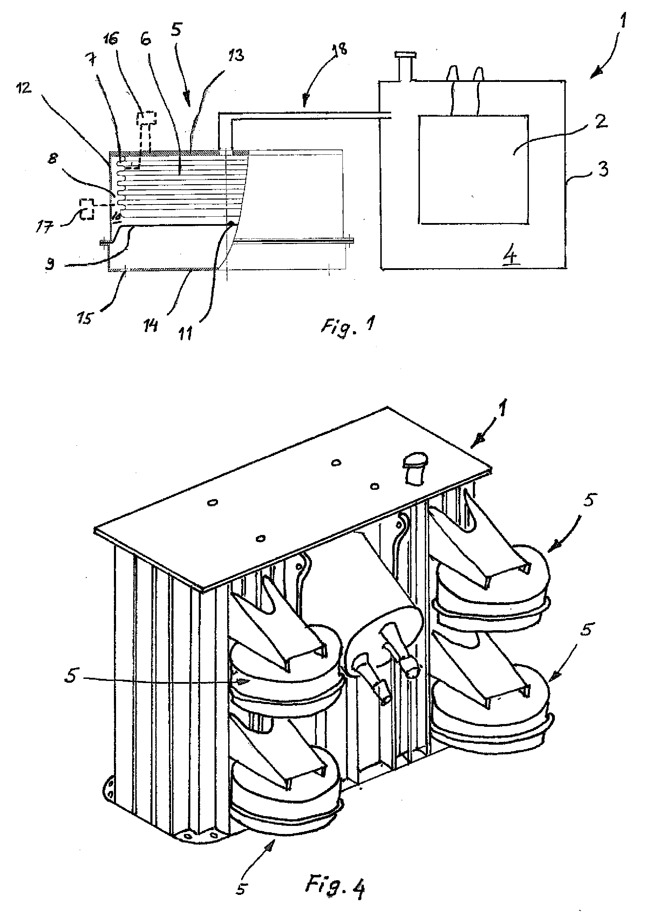

Figure 1 shows schematically the basic structure of the invention and how the present invention operates in connection with a subsea installation. In the example of Figure 1 the subsea installation is a subsea transformer. Reference number 1 shows generally the subsea transformer. The subsea transformer 1 comprises the transformer unit 2 and a tank 3. The tank is filled with insulation medium, i.e. in this case transformer oil. The tank 3 forms an insulation chamber around the transformer unit 2.

In order to compensate volume variations of the insulating medium 4 there is a pressure compensator 5. The pressure compensator 5 comprises a first bellows chamber 6. The first bellows chamber 6 comprises a first bellows part 7. The first bellows part 7 is made of a suitable material, for example of steel.

The first bellows chamber 6 is through a pipe or channel system 18 in flow connection with the insulation chamber formed by the tank 3 so that said bellows chamber 6 can compensate volume variations of the insulating medium 4.

The assembly shown in Figure 1 is wholly surrounded with sea water, i.e. the assembly is placed on the bottom of the sea.

The matters above are widely known in the fields and therefore said matters are not described here in detail.

As told before the problems in prior art solutions relate to corrosion damages in the bellows part of the pressure compensator, i.e. surrounding water, for example surrounding sea water causes corrosion problems in the first bellows part.

According to the basic idea of the invention the first bellows chamber 6 is surrounded by a second bellows chamber 8 comprising an end wall 13, a side wall 12 and a second bellows part 9 formed by a diaphragm 9. The second bellows chamber 8 is configured to form a closed intermediate space around the first bellows chamber. The walls 13 and 12, and the diaphragm 9 of the second bellows chamber are configured to separate at least the bellows parts 7 of the first bellows chamber 6 from the surrounding sea water. The second bellows chamber 8 is further filled with an intermediate medium 10. The second bellows part 9, i.e. the diaphragm 9, of the second bellows chamber 8 is preferably made of a material resistant to surrounding sea water.

In other words the expansive and compressive element of the pressure compensator has two barriers or walls between transformer related space and seawater.

The inner barrier, i.e. the first bellows part 7 is made of metallic bellows construction and the outer barrier, i.e. the second bellows part, the diaphragm 9, is made of rubber material or rubber like material. Said rubber like material can be for example appropriate plastic material or a mixture with rubber material and plastic material. The space between the first bellows part 7 and the second bellows part 9, i.e. the second bellows chamber 8 is filled with the same transformer oil or oil which is mixable with the transformer oil 4 in the first bellows chamber 6 and in the tank 3. There is however no exchange of oil through the first bellows part 7.

The second bellows part, i.e. the diaphragm 9, made of rubber material or like protects the first bellows part 7 made of metal material from corrosion. In this connection it is important to realise that the first bellows part 7 due to flexibility needed must have a typically thin wall construction, and therefore corrosion matters are very important as regards the operation of the device. The typical wall thickness of the first bellows part 7 is in 1 mm scale. In order to have more flexibility and reliability the first bellows part 7 can be constructed also with one or more metallic layers.

The small volume changes of the closed intermediate oil space, i.e. the second bellows chamber 8 between the first and the second bellows parts must also be compensated. According to the invention this is carried out by the second bellows part i.e. the diaphragm 9, and therefore an additional pressure compensator connected to the intermediate space is not needed.

The rubber material used in the second bellows part, i.e. the diaphragm 9 can be for example Nitrile rubber, which is resistant against sea water and after suitable treatment compatible with the transformer oil too.

The second bellows part, i.e. the diaphragm 9 can be made wholly of said rubber or rubber like material. It is however quite possible to put appropriate strengthening material or several strengthening materials to the diaphragm material, for example inside of the diaphragm 9 or/and on the surface of the diaphragm 9 as shown with a reference number 11 for example in Figure 1.

The other walls of the pressure compensator, which are not changing their shape and size, for example side wall 12 of tubular form and end wall 13 can be made for example of thick enough one layer metallic material, like e.g. stainless steel plates. Said walls can however be for example two-layer construction like rubber material/metal material walls.

The pressure compensator of the invention can also be provided with guiding rods (not shown in the Figures) for guiding the first bellows parts to move during compression and/or expansion along defined paths. The guiding rod may be placed into the second bellows chamber whereby said guiding rods are well protected against dirt and debris. The number of said guiding rods can be chosen freely according to the existing need. It is however quite possible also to materialize the pressure compensator without said guiding rods as shown in the Figures.

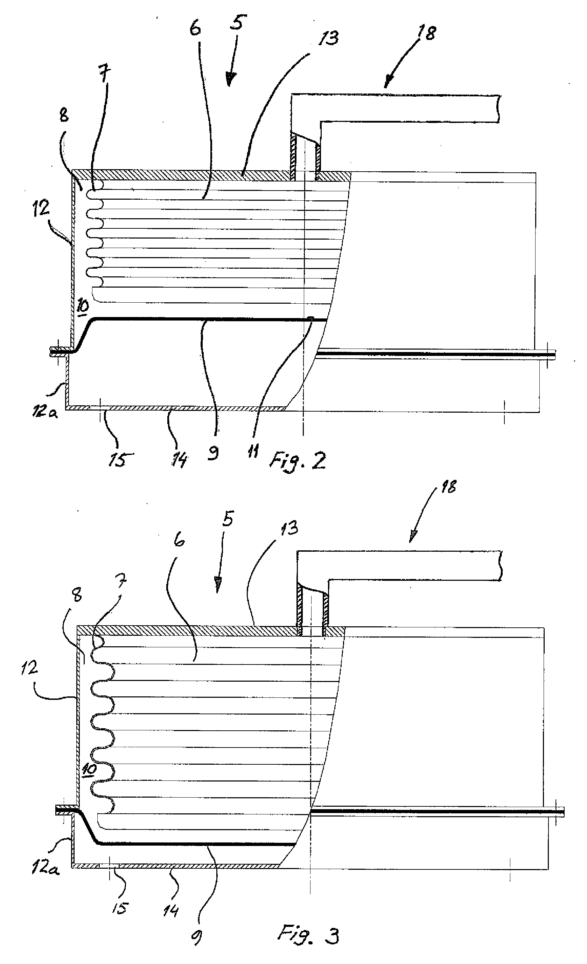

Figures 2 and 3 are sectional drawings showing the pressure compensator of the invention in a compressed situation (Figure 2) and in an expanded situation (Figure 3). The reference numbers used in Figures 2 and 3 correspond to the reference numbers used in Figure 1. The first bellows chamber is filled with the insulating medium 4 and the second bellows chamber 8 is filled with the intermediate medium 10. In the embodiment of Figures 2 and 3 the space under the diaphragm 9 is formed by an element formed by a bottom wall 14 and a side wall part 12a which in the embodiment shown is a cylindrical part. The side wall part 12a forms an extension of the side wall 12. Said element is made of for example metal material. The space formed by the diaphragm 9, the bottom wall 14 and the side wall part 12a is filled with surrounding water, for example sea water flowing through an orifice 15 provided in the bottom wall 15. In the embodiment of Figures 2 and 3 the orifice 15 is made to the bottom wall 14. Said orifice 15 can however be made so that surrounding water, for example sea water flows for through the side wall part 12a or through both the bottom wall 15 and side wall part 12a. Several orifices 15 arranged to the bottom wall 15 or/and side wall part 12a can also be used instead of one shown in Figures 2 and 3.

The element forming the space under the diaphragm 9 is not a critical element, i.e. the invention can be used also without said element, whereby the outer surface of the diaphragm 9 is faced freely to the open surrounding water, for example sea water. The element described above is however very advantageous forming an efficient mechanical safety cover to the diaphragm 9 and offering also excellent and simple fastening properties to the diaphragm 9.

As described above the pressure compensator 5 compensate volume variations of the insulating medium 4. The first bellows part 7 of the first bellows chamber 6 takes care of the volume variations in the insulating medium, i.e. the first bellows part 7 is compressed or expanded according to the volume variations in the insulating medium. Figure 2 shows the first bellows part 7 in a compressed situation and Figure 2 shows the first bellows part 7 in an expanded situation.

As told above further there exist however also small volume changes in the intermediate medium 10, and said small volume changes in the intermediate medium 10 must also be compensated. In the invention said small volume changes of the intermediate medium is compensated by using the second bellows part, i.e. the diaphragm 9, and therefore no additional pressure compensator connected to the intermediate space 8 is needed. No additional pressure compensator is needed because in the invention the volume of the intermediate space 8 changes according to the volume changes of the intermediate medium 10, i.e. the diaphragm 9 is flexible and moves in the way as shown in Figures 2 and 3, and therefore the volume of the intermediate chamber is changed automatically according to the volume changes of the intermediate medium 10.

The number of the pressure compensators connected parallel to the subsea installation, for example to the subsea transformer or to some other possible object to be compensated, is selected so that the total oil volume required can be compensated.

The pressure compensator can also include electrically based corrosion protection means or some other type of corrosion protection means. Said corrosion protection means can be situated also inside the pressure compensator to protect the first bellows part made of metal material. Reference number 16 in Figure 1 shows schematically said corrosion protection means.

The pressure compensator of the invention can also be provided with monitor means for monitoring the amount of surrounding water, for example sea water eventually leaked into the intermediate space, i.e. into the second bellows chamber 8. Reference number 17 in Figure 1 shows said monitoring means.

As discussed above the number of the pressure compensators used in connection with a subsea installation can vary according to the existing need. Typical compensation volume of the pressure compensators required in near future big subsea transformers in hundreds of litres, for example 200 litres, and typical number of compensators needed in one big subsea transformer is from 2 to 6 compensator units. As an example Fig. 4 shows a subsea transformer with four pressure compensators 5.

The embodiments described above are not intended to restrict the invention but only to clarify the basic idea of the invention. It is quite clear that details can be varied freely within the scope of the claims. The invention is described here in connection with subsea transformers. The invention is however not restricted solely to subsea transformers but the invention can also be used in connection with all subsea installations using insulation medium and needing compensation of said insulation medium etc. Insulation medium need not be transformer oil but any other medium or fluid can be used according to the existing need.

## Claims

1. Pressure compensator configured to compensate volume variations of an insulation medium or other liquid of a subsea installation (1), comprising a first bellows chamber (6) comprising a first bellows part (7), the first bellows chamber being connectable to the subsea installation (1) so that it is in flow connection with an insulation medium (4) or liquid chamber (3) of the subsea installation and the walls of the first bellows chamber (6) being configured to separate the insulating medium from surroundings, wherein the first bellows chamber (6) is surrounded by a second bellows chamber (8) comprising an end wall (13), a side wall (12) and a second bellows part formed by a diaphragm (9), the second bellows chamber (8) being configured to form a closed intermediate space around the first bellows chamber (6), the walls of the second bellows chamber being configured to separate at least the bellows parts (7) of the first bellows chamber (6) from the surrounding water, the second bellows chamber (8) being further filled with an intermediate medium (10).

2. Pressure compensator of claim 1, **characterized in that** the second bellows part (9) of the second bellows chamber (8) is made of a material resistant to surrounding water.

3. Pressure compensator of claim 2,**characterized in that** the second bellows part (9) is made of rubber or plastic material or a mixture of said two materials.

4. Pressure compensator of claim 1, **characterized in that** the second bellows part (9) of the second bellows chamber (8) is configured to compensate the volume changes of the intermediate medium (10).

5. Pressure compensator of claim 1, **characterized in that** the intermediate medium (10) is the same medium as the insulation medium (4) of the subsea installation (1) or a medium mixable with the insulation medium (4) of the subsea installation (1).

6. Pressure compensator of claim 3, **characterized in that** the second bellows part (9) is provided with strengthening material or materials (11).

7. Pressure compensator of claim 1, **characterized in that** the intermediate space is provided with measuring elements (17) configured to monitor eventual amount of surrounding water in the intermediate space.

8. Pressure compensator of claim 1, **characterized in that** the pressure compensator is provided with a corrosion protecting means (16).

9. Pressure compensator of claim 1, **characterized in that** the subsea installation (1) is a subsea transformer.

10. Pressure compensator of claim 9, **characterized in that** the insulation medium (4) is transformer oil.

11. Pressure compensator of claim 1, **characterized in that** the diaphragm (9) is covered with an element comprising a bottom end wall (14) and a side wall part (12a), the element being provided with an orifice (15) or orifices (15) for surrounding water.

## Patentansprüche

1. Druckkompensator, der zum Kompensieren von Volumenschwankungen eines Isoliermediums oder einer anderen Flüssigkeit einer Unterwasseranlage (1) ausgebildet ist, mit einer ersten Balgenkammer (6), die ein erstes Balgenteil (7) aufweist, wobei die erste Balgenkammer mit der Unterwasseranlage (1) derart verbindbar ist, dass sie in Fluidverbindung mit einem Isoliermedium (4) oder einer Flüssigkeitskammer (3) der Unterwasseranlage ist, und wobei die Wände der ersten Balgenkammer (6) dazu ausgebildet sind, das Isoliermedium von der Umgebung zu trennen, wobei die erste Balgenkammer (6) von einer zweiten Balgenkammer (8) umgeben ist, welche eine Stirnwand (13), eine Seitenwand (12) und ein durch eine Membran (9) gebildetes zweites Balgenteil aufweist, wobei die zweite Balgenkammer (8) dazu ausgebildet ist, einen geschlossenen Zwischenraum um die erste Balgenkammer (6) zu bilden, wobei die Wände der zweiten Balgenkammer dazu ausgebildet sind, zumindest die Balgenteile (7) der ersten Balgenkammer (6) von dem umgebenen Wasser zu trennen, wobei die zweite Balgenkammer (8) ferner mit einem Zwischenmedium (10) gefüllt ist.

2. Druckkompensator nach Anspruch 1, **dadurch gekennzeichnet, dass** das zweite Balgenteil (9) der zweiten Balgenkammer (8) aus einem Material besteht, das gegenüber umgebendem Wasser beständig ist.

3. Druckkompensator nach Anspruch 2, **dadurch gekennzeichnet, dass** das zweite Balgenteil (9) aus Gummi oder Kunststoff oder einer Mischung der beiden genannten Materialien besteht.

4. Druckkompensator nach Anspruch 1, **dadurch gekennzeichnet, dass** das zweite Balgenteil (9) der zweiten Balgenkammer (8) dazu ausgebildet ist, die Volumenänderungen des Zwischenmediums (10) zu kompensieren.

5. Druckkompensator nach Anspruch 1, **dadurch gekennzeichnet, dass** das Zwischenmedium (10) das gleiche Medium wie das Isoliermedium (4) der Unterwasseranlage (1) oder ein Medium ist, das mit dem Isoliermedium (4) der Unterwasseranlage (1) mischbar ist.

6. Druckkompensator nach Anspruch 3, **dadurch gekennzeichnet, dass** das zweite Balgenteil (9) mit Verstärkungsmaterial oder -materialien (11) versehen ist.

7. Druckkompensator nach Anspruch 1, **dadurch gekennzeichnet, dass** der Zwischenraum mit Messelementen (17) versehen ist, die zur Überwachung eventueller Mengen an umgebendem Wasser in dem Zwischenraum konfiguriert sind.

8. Druckkompensator nach Anspruch 1, **dadurch gekennzeichnet, dass** der Druckkompensator mit einer Korrosionsschutzeinrichtung (16) versehen ist.

9. Druckkompensator nach Anspruch 1, **dadurch gekennzeichnet, dass** die Unterwasseranlage (1) ein Unterwassertransformator ist.

10. Druckkompensator nach Anspruch 9, **dadurch gekennzeichnet, dass** das Isoliermedium (4) Transformatorenöl ist.

11. Druckkompensator nach Anspruch 1, **dadurch gekennzeichnet, dass** die Membran (9) mit einem Element bedeckt ist, das eine untere Endwand (14) und ein Seitenwandteil (12a) aufweist, wobei das Element mit einer Öffnung (15) oder Öffnungen (15) für umgebendes Wasser versehen ist.

## Revendications

1. Compensateur de pression configuré pour compenser les variations de volume d'un milieu isolant ou d'un autre liquide d'une installation sous-marine (1), comprenant une première chambre à soufflet (6) comprenant une première partie de soufflet (7), la première chambre à soufflet pouvant être reliée à l'installation sous-marine (1) de sorte qu'elle soit en communication fluidique avec une chambre de milieu isolant (4) ou de liquide (3) de l'installation sous-marine et les parois de la première chambre à soufflet (6) étant configurées pour séparer le milieu isolant de l'environnement, où la première chambre à soufflet (6) est entourée par une deuxième chambre à soufflet (8) comprenant une paroi d'extrémité (13), une paroi latérale (12) et une deuxième partie de soufflet formée par un diaphragme (9), la deuxième chambre à soufflet (8) étant configurée pour former un espace intermédiaire fermé autour de la première chambre à soufflet (6), les parois de la deuxième chambre à soufflet étant configurées pour séparer au moins les parties de soufflet (7) de la première chambre à soufflet (6) de l'eau environnante, la deuxième chambre à soufflet (8) étant en outre remplie d'un milieu intermédiaire (10).

2. Compensateur de pression de la revendication 1, **caractérisé en ce que** la deuxième partie de soufflet (9) de la deuxième chambre à soufflet (8) est réalisée en un matériau résistant à l'eau environnante.

3. Compensateur de pression de la revendication 2, **caractérisé en ce que** la deuxième partie de soufflet (9) est réalisée en un matériau en caoutchouc ou en plastique ou en un mélange desdits deux matériaux.

4. Compensateur de pression de la revendication 1, **caractérisé en ce que** la deuxième partie de soufflet (9) de la deuxième chambre à soufflet (8) est configurée pour compenser les changements de volume du milieu intermédiaire (10) .

5. Compensateur de pression de la revendication 1, **caractérisé en ce que** le milieu intermédiaire (10) est le même milieu que le milieu isolant (4) de l'installation sous-marine (1) ou un milieu pouvant être mélangé avec le milieu isolant (4) de l'installation sous-marine (1).

6. Compensateur de pression de la revendication 3, **caractérisé en ce que** la deuxième partie de soufflet (9) est munie d'un matériau ou de matériaux de renforcement (11) .

7. Compensateur de pression de la revendication 1, **caractérisé en ce que** l'espace intermédiaire est muni d'éléments de mesure (17) configurés pour surveiller une quantité éventuelle d'eau environnante dans l'espace intermédiaire.

8. Compensateur de pression de la revendication 1, le compensateur de pression étant **caractérisé en ce qu'**il est muni d'un moyen de protection contre la corrosion (16).

9. Compensateur de pression de la revendication 1, **caractérisé en ce que** l'installation sous-marine (1) est un transformateur sous-marin.

10. Compensateur de pression de la revendication 9, **caractérisé en ce que** le milieu isolant (4) est une huile de transformateur.

11. Compensateur de pression de la revendication 1, **caractérisé en ce que** le diaphragme (9) est couvert d'un élément comprenant une paroi d'extrémité inférieure (14) et une partie de paroi latérale (12a), l'élément étant muni d'un orifice (15) ou d'orifices (15) pour l'eau environnante.
